**Europäisches Patentamt**

**European Patent Office**

**Office européen des brevets**

(19)

(11) **EP 1 531 191 A2**

(12) # EUROPEAN PATENT APPLICATION

(43) Date of publication:
**18.05.2005 Bulletin 2005/20**

(51) Int Cl.$^7$: **C23C 16/455**

(21) Application number: **04256919.4**

(22) Date of filing: **09.11.2004**

(84) Designated Contracting States:
**AT BE BG CH CY CZ DE DK EE ES FI FR GB GR HU IE IS IT LI LU MC NL PL PT RO SE SI SK TR**
Designated Extension States:
**AL HR LT LV MK YU**

(30) Priority: **13.11.2003 US 712495**

(71) Applicant: **THE BOC GROUP, INC.**
**Murray Hill, New Providence,**
**New Jersey 07974 (US)**

(72) Inventor: **Jansen, Frank**
**San Jose California 95132 (US)**

(74) Representative: **Booth, Andrew Steven et al**
**The BOC Group plc,**
**Chertsey Road**
**Windlesham, Surrey GU20 6HJ (GB)**

(54) **Atomic layer deposition process and apparatus**

(57)     An atomic layer deposition apparatus and method is described in which precursor gas is delivered to a reactor chamber under a pressure gradient without pumping.

FIG. 1A

FIG. 1B

FIG. 1C

FIG. 1D

FIG. 1E

## Description

This invention is directed to atomic layer deposition. More particularly this invention provides an apparatus and process in which precursor gas is delivered to a process reactor chamber at reduced pressure from an auxiliary chamber through a pressure equalization process. The precursor gas flows into the reactor chamber from the auxiliary chamber solely due to a pressure gradient between the two chambers thereby reducing use of excess precursor gas and ensuring spatial uniformity of layers produced in the atomic layer deposition process.

Atomic layer deposition is a method of depositing very thin films onto a surface. Individual precursor gases are pulsed onto the surface, typically a wafer, in a sequential manner without mixing the precursors in the gas phase. Each precursor gas reacts with the surface to form an atomic layer in a way such that only one layer at a time can be deposited onto the surface.

Preferably, each of the precursor gases reacts with each other only at surfaces where they are deliberately deposited. To avoid direct contact between the different precursor gases, introduction of precursor gases to the process reactor chamber is often interleaved with a flow of purge gas.

There are several drawbacks to current procedures for introducing precursor gas to the process reactor chamber. The thickness of the layer of precursor adsorbed onto the target surface depends upon the gas impingement rate on the target surface, and thus the local pressure. When precursor gas is delivered over a flow line, the pressure varies over the flow line and consequently, the gas will not be adsorbed uniformly over the target surface.

Second, the major portion of the precursor gas delivered is not used to form the monolayer, but flowed through the system and thus wasted. The relatively slow time response of mass flow controllers used to meter the precursor gas into the process reactor chamber is a contributing factor to the inefficiency of gas usage. In fact, after mass flow controllers are set to deliver a predetermined flow to a process reactor chamber as part of the atomic layer process, the flow is often kept constant and merely switched between the process reactor chamber and a disposal pump. In addition to the enormous waste of precursor gas, this procedure results in pumping problems due to volume reactions in the foreline, the pumps and the abatement system.

In a first aspect, the present invention provides an atomic layer deposition arrangement comprising a process reactor chamber having at least one inlet and at least one outlet, a first auxiliary chamber for receiving a first precursor gas coupled to the process reactor chamber through a first flow path, at least one precursor gas valve in the first flow path between an inlet of the process reactor chamber and the auxiliary chamber, a second auxiliary chamber for receiving a second precursor gas coupled to the process reactor chamber through a second flow path, at least one second precursor gas valve in the second flow path between an inlet of the process reactor chamber and the second auxiliary chamber, and an exhaust pump coupled to the at least one outlet of the process reactor chamber. The first flow path and second flow path do not include a mass flow controller.

In a second aspect the present invention provides a method of delivering precursor gas to an atomic layer deposition chamber comprising closing a first precursor gas valve located in between a first auxiliary chamber and an inlet of a process reactor chamber, closing a second precursor gas valve located in between a second auxiliary chamber and an inlet of the process reactor chamber, reducing pressure in the process reactor chamber, opening the first precursor gas valve, allowing a first precursor gas to flow from the first auxiliary chamber to the process reactor chamber solely under a pressure gradient, closing the first precursor gas valve, reducing pressure in the process reactor chamber, opening the second precursor gas valve, and allowing a second precursor gas to flow from the second auxiliary chamber to an inlet of the process reactor chamber solely under a pressure gradient.

Preferred features of the present invention will now be described, by way of example only, with reference to the accompanying drawings, in which:-

Figure 1(a)-1(e) are schematic representations of a method and arrangement for delivery of a first precursor gas;

Figure 2(a)-2(e) are schematic representations of a method and arrangement for delivery of a second precursor gas;

Figure 3 is an illustration of an atomic layer deposition arrangement; and

Figure 4 is an illustration of an atomic layer deposition arrangement including a purge gas.

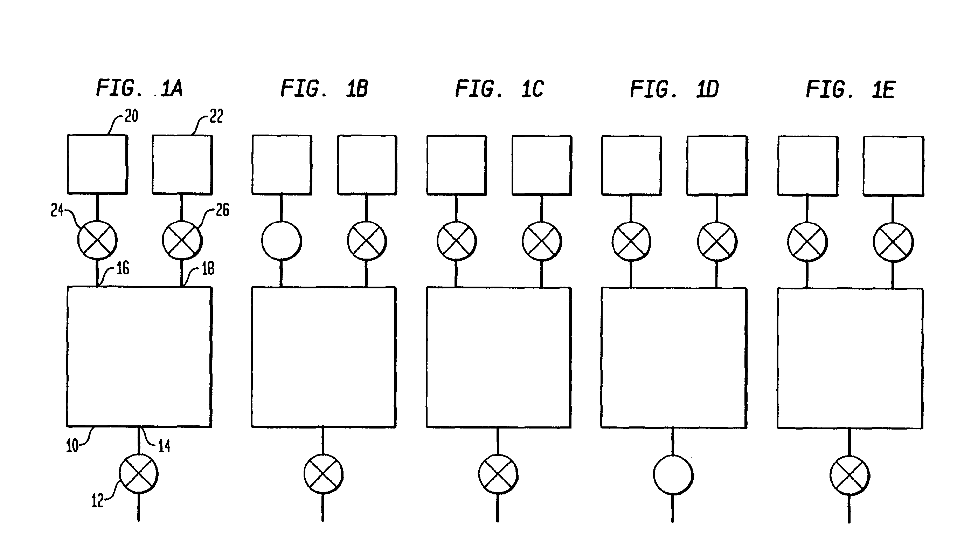

A method of delivering a first precursor gas to a process reactor chamber 10 is illustrated in Figure 1. The process reactor chamber 10 is coupled to an exhaust pump (not shown) via a vacuum valve 12 coupled to an outlet 14 of the process reactor chamber 10. The process reactor chamber 10 is also coupled through inlets 16 and 18 to a first auxiliary chamber 20 having a volume $V_1$ containing a first precursor gas and a second auxiliary chamber 22 having a volume $V_2$ containing a second precursor gas. Gas valves 24 and 26 are located in between the first auxiliary chamber 20 and process reactor chamber inlet 16, and in between the second auxiliary chamber 22 and process reactor chamber inlet 18, respectively.

In this method, the pressure in process reactor chamber 10 is reduced by opening valve 12 coupled to the exhaust pump with valves 24 and 26 in a closed position as shown in Fig. 1(a). Next, as shown in Fig. 1(b) valve 24 is opened and the first precursor gas discharges from first auxiliary chamber 20 into process reactor chamber 10 due to the pressure gradient between first auxiliary chamber 20 and process reactor chamber 10. The first precursor gas will apportion itself between process reactor chamber 10 and first auxiliary chamber 20 according to chamber volumes, approximately in accordance with the following equation,

$$P_1 V_1 = Pr_1 (V_1 + Vr)$$

where Vr is the process reactor chamber volume, $P_1$ is the pressure in the first auxiliary chamber before discharge and $Pr_1$ is the pressure in the first auxiliary chamber and process reactor chamber after discharge.

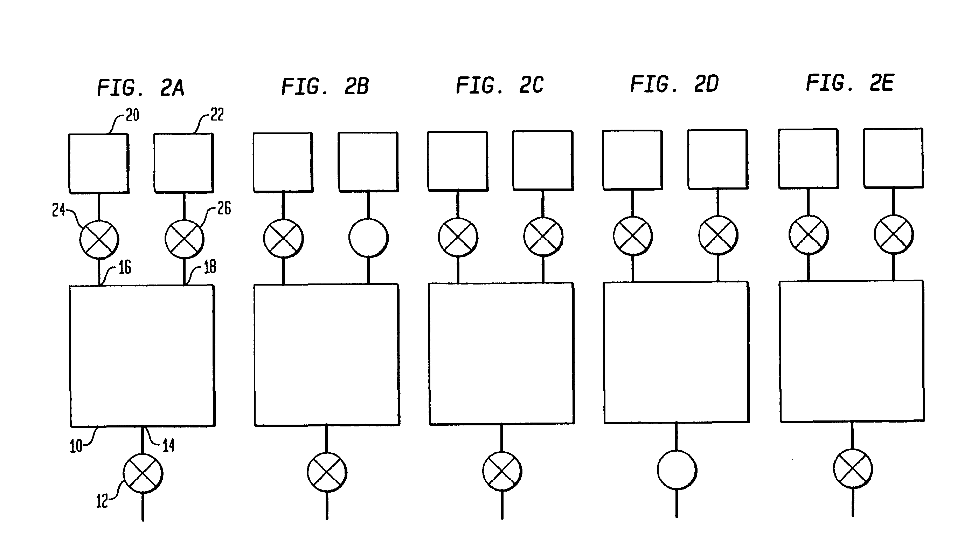

Apportionment of the first precursor gas between first auxiliary chamber 20 and process reactor chamber 10 is illustrated in Fig. 1(b). After discharge of the first precursor gas into the process reactor chamber 10, valve 24 is closed as illustrated in Fig. 1(c). Valve 12 is then opened and pressure reduced in process reactor 10 as shown in Fig. 1(d). After a reduced pressure is achieved in process reactor 10, valve 12 is closed as shown in Fig. I(e) and Fig. 2(a).

Next, as shown in Fig. 2(b), valve 26 is opened and the second precursor gas discharges from the second auxiliary chamber 22 into process reactor chamber 10 due to the pressure gradient between the second auxiliary chamber 22 and process reactor chamber 10. The second precursor gas will apportion itself between process reactor 10 and second auxiliary chamber 22 according to chamber volume, approximately in accordance with the following equation

$$P_2 V_2 = Pr_2 (V_2 + Vr)$$

Where $P_2$ is the pressure in auxiliary chamber 22 before discharge and $Pr_2$ is the pressure in the second auxiliary chamber and process reactor chamber after discharge. After discharge of the second precursor gas into the process reactor chamber 10, valve 26 is closed as illustrated in Fig. 2(c). Valve 12 is then opened and pressure reduced in process reactor chamber 10 as shown in Fig. 2(d). After a reduced pressure is achieved in process reactor 10, valve 12 is closed as shown in Fig. 2(e).

The above is repeated, alternating gas discharge from first auxiliary chamber 20 and second auxiliary chamber 22 until the desired thickness of deposition layer is obtained.

The first auxiliary chamber 20 and second auxiliary chamber 22 may be coupled by an intermittent valve connection to any suitable gas supply and recharged in between alternating discharge of the first precursor gas and second precursor gas to the process reactor chamber.

As is well known by those of skill in the art, the gas supply source can be a pressurized gas source such as a gas cylinder or a chamber including a solid or liquid substance. The chamber is heated to vaporize the substance and obtain a desired vapor pressure. The first auxiliary chamber 20 and second auxiliary chamber 22 may itself contain a solid or liquid substance and be heated to a predetermined temperature to vaporize the substance and obtain the desired vapor pressure.

Optionally, process reactor chamber 10 may be purged with an inert gas after evacuation as in Fig. 1(d) or Fig. 2(d) and prior to introduction of an alternate precursor gas as in Fig. 1(b) of Fig. 2(b).

Precursors for use in ALD are well known to those skilled in the art. Examples of commonly used precursors include $Zr(OC_4H_9)_4$ and $O_2$, $ZrCl_4$ and $H_2O$, $HfCl_4$ and $H_2O$, 2,2,6,6-tetramethyl-3,5-heptanedionato Yttrium ("$Y(thd)_3$") and $O_3$, $Al(CH_3)_3$ and $H_2O$, $Al(CH_3)_3$ and $O_2$, dimethylaluminumhydride ethylene-piperidine-pyrocatechol ("DMAH-EPP") and $NH_3$, tetrakis dimethylamino titanium ("TDMAT") and $NH_3$, $TiCl_4$ and $NH_3$, $TiCl_4$ and $H_2/N_2$, $TiCl_4$ and $H_2$, $TiCl_4$ and $H_2O$, $TiCl_4$ and $O_2$, $Ti(OCH(CH_3)_2))_4$ and $O_2$, $TaCl_5$ and $NH_3$, Ta$(OC_2H_5)_5$ and $H_2O$, strontiumbis (triisopropylcyclopentadienyl) ("$Sr(C_5iPr_3H_2)_2$")and $O_2$, $Zn(CH_2CH_3)_2$ and $H_2O$, and tetrakis (organo-amino) hafnium compounds, for example tetrakis (dimethylamino) hafnium, tetrakis (diethylamino) hafnium, tetrakis (ethylmethylamino) hafnium and $H_2O$.

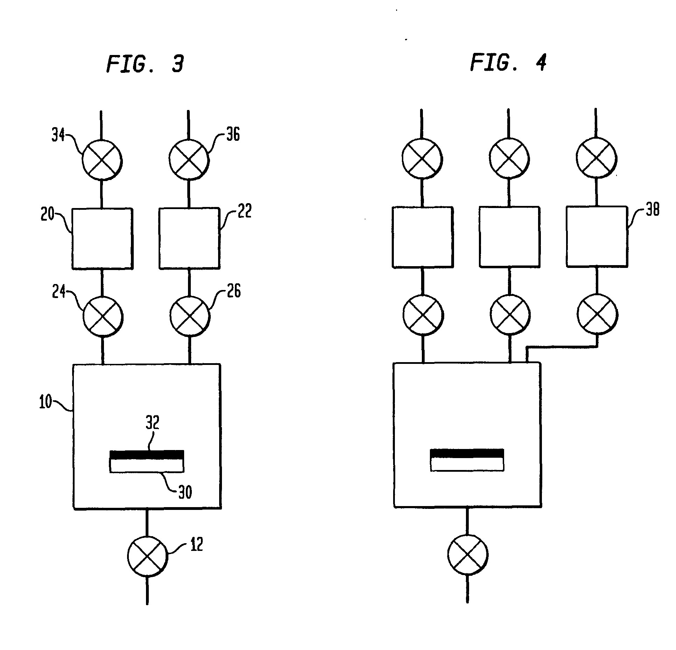

Figure 3 illustrates an embodiment for the manufacture of thin films. In the interior of a process reactor chamber 10 is a substrate holder 30 which can be heated by electrical power to a predetermined temperature. This temperature is referred to as the deposition temperature. A substrate 32 is mounted on the substrate holder such that good thermal contact is established between substrate holder 30 and substrate 32. By conducting the aforementioned methods, thin films are deposited at the exposed surface of substrate 32. The process reactor chamber 10 is made of stainless steel and is vacuum-pumped by a vacuum pumping system (not shown). The vacuum system pumping system is connected to the process reactor chamber 10 by means of a high conductance vacuum valve 12. Vacuum valve 12 is either in an open or closed position, transitioning between these states with a fast acting mechanism. In this embodiment the connecting vacuum valve is manufactured by BOC Edwards, model number QVA060. The interior of the process reactor chamber 10 is pumped down to a base pressure of $10^{-5}$ Torr by the evacuation system when vacuum valve 12 is in its open position. The pressure of process reactor chamber 10 is typically less than $10^{-3}$ Torr 10 minutes after vacuum valve 12 has been closed, indicating leak tightness of the vessel. In normal operation, there is no provision to either measure or control the pressure of process reactor chamber 10.

The process reactor chamber 10 is connected to a source-material delivery system consisting of two vessels 20 and 22 connected by gas valves 24 and 26 respectively, to the process reactor chamber 10. Vessels 20 and 22 are made of stainless steel. Vessel 20 and its connecting valve 24 can be electrically heated to temperatures up to 300° C. In this embodiment, the connecting high temperature valve is provided by Fujikin, model number FWBR-71-9.52. Vessels 20 and 22 are connected via valves 34 and 36, respectively to sources of material at constant pressure. In the case that two gases are used, these sources are usually gas cylinders with regulators to ensure a constant delivery pressure. In the case, one of the sources is liquid or solid at room temperature, precursor material is preloaded into vessel 20 through either valve 34 or through a fill opening in the wall of vessel 20 which can be closed gas tight.

For the apparatus and method shown in Figure 3 and by way of example, the net volume enclosed between valves 24, 26 and 12 is 378 cc. Low vapor pressure materials, either liquids or solids are loaded in vessel 20. This vessel and valve 24 are heated to a predetermined temperature referred to as the vaporization temperature. The net volume of vessel 20 is 231 cc and the volume of vessel 22 is 37 cc.

All the valves in the system are opened and closed at pre-programmed times by a system controller, typically a computer, a programmable logic controller (PLC) or a microprocessor.

Example 1

For deposition of titanium nitride films, one of the source materials used is titaniumtetrachloride while the second gas is ammonia gas. Thirty cc of titaniumtetrachloride is loaded at room temperature as a liquid into vessel 20. The ammonia gas is supplied to vessel 22 from a gas cylinder with a regulator set at 30 psi (gauge pressure). The deposition process is started by affixing a silicon wafer which is the substrate 32, to the substrate holder 30, then closing valves 24 and 26 and opening the vacuum valve 12, thus evacuating the process reactor chamber. The substrate holder 30 and, by inference the substrate 32, is heated to the deposition temperature of 400° C. The vessel 20 containing titaniumtetrachloride and its connecting valve 24 are heated to a vaporization temperature of about 60° C. Valve 26 is briefly opened to evacuate vessel 22 and closed. When valve 26 has reached closure, valve 36 is opened for a time long enough for vessel 22 to be charged with ammonia gas at a pressure of 30 psi. In this system, valve 26 is kept open for 2 seconds. Valve 36 is opened and closed at regular intervals to keep the vessel 22 charged at 30 psi.

Once the pressure in vessel 20 reaches 60 Torr, valve 12 is closed and when it reaches closure valve 24 is opened, kept open for 1 second and then closed. From previous diagnostic pressure measurements, it is known that the process vessel is now filled with titaniumtetrachloride at a pressure between 10 and 20 Torr. One second after valve 24 reaches closure, valve 12 is opened for 15 seconds and then closed. From previous measurements it is known that the pressure of titanium chloride in the process vessel is now less than $10^{-4}$ Torr. At the moment that valve 12 reaches closure, valve 26 is opened for 1 second. From previous diagnostic pressure measurements it is known that ammonia is now present in the process vessel at a pressure of 20 Torr. One second after valve 26 reaches closure, valve 12 is opened for 15 seconds and then closed. From previous measurements it is known that the pressure of ammonia in the process vessel is now less than $10^{-4}$ Torr.

This sequence has exposed the surface of the silicon wafer 32 to titaniumtetrachloride and to ammonia, respectively, under isobaric conditions. This complete cycle is referred to as one deposition cycle. In this deposition cycle a monolayer of a film which is substantially titanium nitride is uniformly deposited on the surface of the silicon wafer 32. A desired film thickness is obtained by repeating the deposition cycle a sufficient number of times. After 50 deposition cycles all valves are closed, the substrate temperature is allowed to decrease to room temperature and the process reactor chamber 10 is vented to atmospheric pressure. The silicon wafer substrate with the titanium nitride film is removed from the system and the deposited film is measured for thickness uniformity across the wafer surface. The thickness uniformity is found to be better than the measurement error of the measurement apparatus and the non-uniformity is estimated to be less than 1%.

Example 2

In a further embodiment shown in Figure 4, a third vessel 38, with internal volume of 73 cc but otherwise identical to the vessels 20 and 22 is charged with 150 psi (gauge pressure) of argon. This vessel is discharged to process reactor chamber 10 right after valve 12 is opened to drive the titaniumtetrachloride and then the ammonia out of the system and decrease the pumping time to 5 seconds instead of 15 seconds in both cases.

The invention has the desirable effect of improving the thickness uniformity of a film deposited by means of an atomic layer deposition method whereby the gases are in contact with the substrate surface under conditions of zero flow. Another advantage of this invention is the simplicity of the apparatus because the process obviates the need for complicated measurements of flow and pressure.

The atomic layer deposition arrangement and process of the invention minimizes waste of precursor gases, decreases process costs and minimizes problems associated with delivery of precursor gas to the process reactor chamber by pumping. The adsorption of precursor gas by a substrate in a process without gas flow by pumping ensures the spatial uniformity of the layer deposited on the substrate.

Although preferred embodiments are specifically illustrated and described herein above, it will be appreciated that many modifications and variations of the present invention are possible in light of the above teachings and within the purview of the appended claims without departing from the scope of the invention.

## Claims

1. An atomic layer deposition apparatus comprising:

   a process reactor chamber (10) having at least one inlet (16, 18) and at least one outlet (14),
   a first auxiliary chamber (20) for receiving a first precursor gas and coupled to the process reactor chamber (10) through a first flow path extending between an inlet (16) of the process reactor chamber (10) and the first auxiliary chamber (20),
   at least one first precursor gas valve (24) in the first flow path,
   a second auxiliary chamber (22) for receiving a second precursor gas and coupled to the process reactor chamber (10) through a second flow path, between an inlet (18) of the process reactor chamber (10) and the second auxiliary chamber (22),
   at least one second precursor gas valve (26) located in the second flow path and
   an exhaust pump coupled to the at least one outlet (14) of the process reactor chamber(10).

2. An atomic layer deposition apparatus according to Claim 1, wherein the first auxiliary chamber (20) is coupled to a first precursor gas supply and the second auxiliary chamber (22) is coupled to a second precursor gas supply.

3. An atomic layer deposition apparatus according to Claim 2, wherein the first second precursor gas supplies are each configured to deliver gas to the respective auxiliary chamber at a substantially constant delivery pressure.

4. An atomic layer deposition apparatus according to Claim 2 or Claim 3, wherein the first precursor gas supply and the second precursor gas supply are the same or different and are obtained from a source selected from the group consisting of a pressurized gas tank and a heated chamber.

5. An atomic layer deposition apparatus according to Claim 4, wherein the first precursor gas supply comprises titaniumtetrachloride.

6. An atomic layer deposition apparatus according to Claim 4 or Claim 5, wherein the second precursor gas supply comprises ammonia.

7. An atomic layer deposition apparatus according to any preceding claim, wherein the process reactor chamber (10) includes a substrate holder (30).

8. An atomic layer deposition apparatus according to any preceding claim, comprising a valve (12) in between the outlet (14) of the process reactor chamber (10) and the exhaust pump.

9. An atomic layer deposition apparatus according to any preceding claim, comprising a third auxiliary chamber (38) for receiving a purge gas, the third auxiliary chamber (38) being coupled to the process reactor chamber (10).

10. An atomic layer deposition apparatus according to Claim 9, wherein the third auxiliary chamber (38) is coupled to a purge gas supply.

11. An atomic layer deposition apparatus according to Claim 9 or Claim 10, comprising a valve in between the third auxiliary chamber (38) and the process reactor chamber (10).

12. An atomic layer deposition apparatus according to any preceding claim, wherein a mass flow controller is absent from the first flow path and second flow path.

13. A method of delivering precursor gas comprising:

   closing a first precursor gas valve located in between a first auxiliary chamber and an inlet of a process reactor chamber,
   closing a second precursor gas valve located in between a second auxiliary chamber and an inlet of the process reactor chamber,
   reducing the pressure in the process reactor chamber,
   opening the first precursor gas valve,
   allowing a first precursor gas to flow from the first auxiliary chamber to an inlet of the process reactor chamber solely under a pressure gradient,
   closing the first precursor gas valve,
   reducing the pressure in the process reactor chamber,
   opening the second precursor gas valve, and
   allowing a second precursor gas to flow from the second auxiliary chamber to an inlet of the process reactor chamber solely under a pressure gradient.

14. A method of delivering precursor gas according to Claim 13, further comprising purging the process reactor chamber with an inert gas, and reducing the pressure in the process reactor chamber prior to opening the second precursor gas valve.

15. A method of delivering precursor gas according to Claim 14, further comprising purging the process reactor chamber with an inert gas, and reducing the pressure in the process reactor chamber prior to opening the first precursor gas value.

16. A method of delivering precursor gas according to Claim 14 or Claim 15, wherein the inert gas is argon.

17. A method of delivering precursor gas according to any of Claims 13 to 16, wherein the first precursor gas is selected from the group consisting of Zr $(OC_4H_9)_4$, $ZrCl_4$, $HfCl_4$, $Hf(N(CH_3)_2)_4$, $Hf(N(CH_2CH_3)_2)_4$, $Hf(N(CH_3C_2H_5))_4$, $Y(thd)_3$, $Al(CH_3)_3$, DMAH-EPP, TDMAT, $TiCl_4$, $Ti(OCH(CH_3)_2))_4$, $TaCl_5$, $Ta(OC_2H_5)_5$, $Sr(C_5iPr_3H_2)_2$ and $Zn(CH_2CH_3)_2$.

18. A method of delivering precursor gas according to any of Claims 13 to 17, wherein the second precursor gas is selected from the group consisting of $NH_3$, $O_2$, $H_2O$, $O_3$, $N_2$ and $H_2$.

19. A method of delivering precursor gas according to any of Claims 13 to 18, further comprising providing a first precursor gas supply coupled to the first auxiliary chamber and a second precursor gas supply coupled to the second auxiliary chamber.

20. A method of delivering precursor gas according to Claim 19, further comprising flowing first precursor gas from the first precursor gas supply to the first auxiliary chamber after closing the first precursor gas valve and flowing second precursor gas from the second precursor gas supply to the second auxiliary chamber after closing the second precursor gas valve.

21. A method of delivering precursor gas according to any of Claims 13 to 20, wherein the first precursor gas comprises titaniumtetrachloride and the second precursor gas comprises ammonia.

FIG. 1A    FIG. 1B    FIG. 1C    FIG. 1D    FIG. 1E

FIG. 2A    FIG. 2B    FIG. 2C    FIG. 2D    FIG. 2E

EP 1 531 191 A2

FIG. 4

FIG. 3